# EUROPÄISCHE PATENTSCHRIFT

(11) **EP 1 141 142 B1**
(45) Veröffentlichungstag und Bekanntmachung des Hinweises auf die Patenterteilung: **09.10.2002**
(21) Anmeldenummer: 99963557.6
(22) Anmeldetag: 16.12.1999
(51) Int. Cl.: C09B 67/46

(54) **VERBESSERTES VERFAHREN ZUR HERSTELLUNG THERMISCH SPALTBARER, LÖSLICHER PIGMENTDERIVATE**
IMPROVED METHOD FOR PRODUCING THERMALLY CLEAVABLE, SOLUBLE PIGMENT DERIVATIVES
AMELIORATION APPORTEE A UN PROCEDE POUR PRODUIRE DES DERIVES DE PIGMENTS SOLUBLES, POUVANT ETRE DECOMPOSES THERMIQUEMENT

(30) Priorität: 29.12.1998 CH 258598
(43) Veröffentlichungstag der Anmeldung: 10.10.2001
(73) Patentinhaber: Ciba Specialty Chemicals Holding Inc., 4057 Basel (CH)
(72) Erfinder: Schacht, Hans-Thomas, D-79618 Rheinfelden (DE); Sreenivasan, Ramaswami, Borivli (West) Mumbai 400 103 (IN); Chandrasekhar, Mudaliar Dayal, Mumbai 400 019 (IN); MOEGLE, Gilbert, F-68510 Magstatt-le-Bas (FR); WAGNER, Barbara, D-81739 München (DE); MONNIER, Charles, Edward, CH-4103 Bottmingen (CH)
(86) Internationale Anmeldenummer: EP9910006
(87) Internationale Veröffentlichungsnummer: WO00039221

(56) Entgegenhaltungen:
- EP-A- 0 761 772
- WO-A-98/32802

## Beschreibung

Thermisch spaltbare, lösliche Pigmentderivate (manchmal auch Latentpigmente genannt) haben kürzlich an Bedeutung gewonnen. Es ist bekannt geworden, dass sie mit Vorteil nicht nur in teuren Spitzentechnologien wie zum Beispiel Farbfiltern, sondern auch zum Beispiel in Holz verwendet werden können. Damit wachsen auch die Ansprüche an Herstellungsverfahren zu deren Herstellung in hoher Reinheit.

Die Herstellung löslicher Pigmentderivate ist aus EP 648 817 und WO 98/32802 bekannt. Pigmente werden dabei unter anderem mit Dicarbonaten in einem Lösungsmittel umgesetzt, gegebenenfalls in Gegenwart eines Katalysators. Etliche Lösungsmittel sind offenbart, darunter auch aromatische wie Benzol, Toluol, Xylol, Anisol, Chlorbenzol und Pyridin. Bevorzugt sind die sehr polaren Lösungsmittel N,N-Dimethylformamid, N-Methylpyrrolidon oder Tetrahydrofuran. In den Beispielen werden ausschliesslich N,N-Dimethylformamid, N,N-Dimethylacetamid oder Tetrahydrofuran verwendet.

Es hat sich jedoch herausgestellt, dass diese Methode nicht immer in gewünschtem Mass befriedigende Resultate ergibt. Manche Pigmente ergeben unerklärlich tiefe Ausbeuten oder lassen sich nur teilweise umsetzen, wobei erhaltengebliebene Hydroxy- oder Amidgruppen die erwünschte Solubilisierung (hohe Auflösbarkeit) des Produktes beeinträchtigen. Andere Pigmente reagieren besser, aber die daraus gewonnenen rohen löslichen Pigmentderivate weisen eine unbefriedigende Reinheit oder eine ungenügende Lagerstabilität auf, so dass komplizierte Reinigungsstufen anfallen. Wiederum andere Pigmente ergeben unerwartete Probleme im Pilot- oder Produktionsmassstab.

Es ist nun gefunden worden, dass bestimmte Pigmente mit überraschend besseren Resultaten solubilisiert werden können, wenn man die Reaktion mit einem Pyrokohlensäurediester in einem aromatischen Lösungsmittel durchführt. Sowohl die Ausbeute als auch die Reinheit sind deutlich höher, und es lassen sich mehr solubilisierende Gruppen in das Pigment einbauen. Die erfindungsgemässe Methode ist insbesondere auch hervorragend zur Herstellung von Latentpigmenten in grösseren Mengen geeignet (≥1 Mol).

Es ist an sich sehr überraschend, dass man eine vollständigere Umsetzung ausgerechnet in relativ apolaren Lösungsmitteln bekommt, worin sich die Pigmente und daraus erhältlichen löslichen Pigmentderivate weniger löslich sind, als in bisher verwendeten Lösungsmitteln.

Die Erfindung betrifft daher ein Verfahren zur Herstellung einer Verbindung der Formel A(D)ₓ(E)_{y} (I) durch Reaktion einer Verbindung der Formel A(H)ₓ(H)_{y} mit einem Pyrokohlensäurediester der Formel 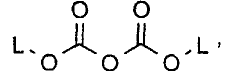 worin
x und y unabhängig voneinander je eine ganze Zahl von 0 bis 6 bedeuten, jedoch nicht gleichzeitig x und y die Zahl 0,
A für den Rest eines Chromophors der Chinacridon-, Anthrachinon-, Perylen-, Indigo-, Chinophthalon-, Indanthron-, Isoindolinon-, Isoindolin-, Dioxazin, Azo-, Phthalocyanin- oder Diketopyrrolopyrrol-reihe steht, der über ein oder mehrere N-Atome mit x Gruppen D und über ein oder mehrere O-Atome mit y Gruppen E verbunden ist, wobei diese N-Atome und O-Atome Teil des Restes A bilden,
jede Gruppe D oder E unabhängig von den anderen für Wasserstoff oder eine Gruppe der Formel 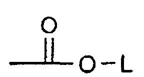 steht, wobei mindestens eine Gruppe D oder E nicht Wasserstoff ist, und L eine beliebige, zur Solubilisierung geeignete Gruppe bedeutet,
in Gegenwart einer Base als Katalysator, dadurch gekennzeichnet, dass diese Reaktion in einem aromatischen oder heteroaromatischen Lösungsmittel stattfindet, ausgewählt aus unsubstituiertem oder mit 1 bis 3 C₁-C₂₄Alkyl, Phenyl, Benzyl, C₁-C₂₄Alkoxy, Phenoxy, C₁-C₂₄Alkylthio, Halogen und/oder Nitro substituiertem Benzol, Diphenyl, Pyridin, Chinolin und Pyrrol sowie beliebigen Gemischen davon.

Aromatische Lösungsmittel sind bevorzugt. Besonders bevorzugt ist .unsubstituiertes oder mit 1 bis 3 C₁-C₆Alkyl, C₁-C₆Alkoxy oder Halogen substituiertes Benzol, beispielsweise Toluol, o-Xylol, Mesitylen oder Isopropylbenzol. Es sind auch aromatische Gemische verwendbar, zum Beispiel Dowtherm® A.

A steht bevorzugt für den Rest eines Chromophors der Monoazo-, Disazo- oder Phthalocyanin-reihe. Vorzugsweise weist A an jedem mit x Gruppen D verbundenen N-Atom mindestens eine unmittelbar benachbarte oder konjugierte Carbonylgruppe auf.

Bevorzugt ist die Herstellung löslicher Pigmentderivate der Formel A(D)ₓ(E)_{y} (I), worin zumindest eine Gruppe D, welche ungleich Wasserstoff ist, am N-Atom einer Hydrazonoder Sulfonamidgruppe gebunden ist, oder worin zumindest eine Gruppe E, welche ungleich Wasserstoff ist, am O-Atom eines Enols, Phenols oder Naphthols gebunden ist. Es können aber mehrere, oder sogar alle Gruppen D und/oder E, an solchen N- oder O-Atomen gebunden sein.

Die für die Verwendung in Spitzentechnologien erwünschte vollständige Umsetzung aller substituierbare Wasserstoffatome hat sich nach bisherigen Verfahren bei mehr als 3 substituierbaren Wasserstoffatomen überraschend bei den obengenannten bevorzugten Pigmentklassen als unmöglich erwiesen. Besonders bevorzugt ist daher die Herstellung von Pigmentderivaten der Formel A(D)ₓ(E)_{y} (I) enthaltend von 4 bis 8, insbesondere von 5 bis 8, Gruppen D und E, welche nicht Wasserstoff sind. Ganz besonders bevorzugt ist dabei die Herstellung von Pigmentderivaten der Formel A(D)ₓ(E)_{y} (I), worin alle Gruppen D und E je für eine Gruppe der Formel 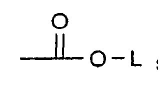 stehen.

Bei den Spitzentechnologien handelt es sich neben Farbfiltern auch um Anwendungen auf eloxiertem Aluminium oder künstlichen Keramiken, welche Gegenstand von parallelen Patentanmeldungen sind.

Als Beispiel einer Gruppe D, welche ungleich Wasserstoff ist und am N-Atom einer Hydrazon- oder Sulfonamidgruppe gebunden ist, oder einer Gruppe E, welche ungleich Wasserstoff ist und am O-Atom eines Enols, Phenols oder Naphthols gebunden ist, seien lösliche Pigmentderivate mit folgenden Teilstrukturen genannt:

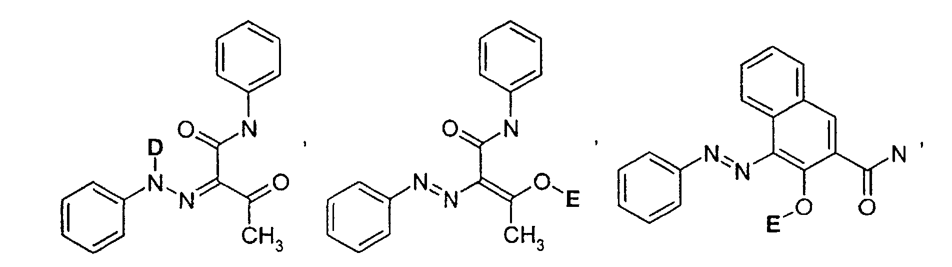

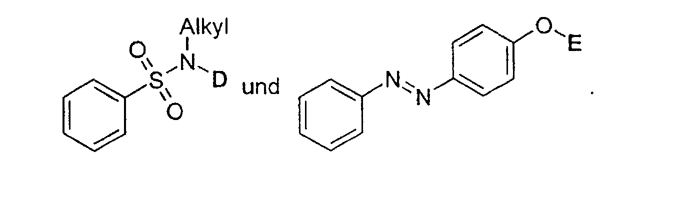

Meistbevorzugt ist die Herstellung von löslichen Pigmentderivaten aus Colour Index Pigment Yellow 13, Pigment Yellow 93, Pigment Yellow 94, Pigment Yellow 95, Pigment Yellow 128, Pigment Yellow 154, Pigment Red 185 und Pigment Red 222.

Zur Solubilisierung von Pigmenten geeignete Gruppen sind zum Beispiel aus den zuvor angegebenen Publikationen oder aus EP 761 772 bekannt.

L kann eine beliebige, zur Solubilisierung von Pigmenten bekannte Gruppe sein.

Bevorzugt steht L für eine Gruppe der Formel 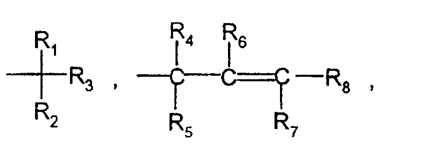 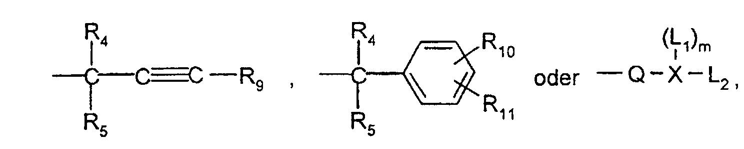 worin R₁, R₃und R₂ unabhängig voneinander C₁-C₆Alkyl bedeuten,
R₄ und R₅ unabhängig voneinander C₁-C₆Alkyl, durch O, S oder N(R₁₂) unterbrochenes C₁-C₆Alkyl, unsubstituiertes oder durch C₁-C₆Alkyl, C₁-C₆Alkoxy, Halogen, Cyano oder Nitro substituiertes Phenyl oder Biphenyl bedeuten,
R₆, R₇ und R₈ unabhängig voneinander Wasserstoff oder C₁-C₆Alkyl bedeuten,
R₉ Wasserstoff, C₁-C₆Alkyl oder eine Gruppe der Formel 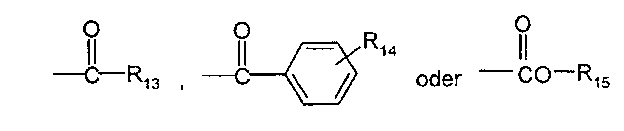 bedeutet,
R₁₀ und R₁₁ unabhängig voneinander Wasserstoff, C₁-C₆Alkyl, C₁-C₆Alkoxy, Halogen, Cyano, Nitro, N(R₁₂)₂, unsubstituiertes oder durch Halogen, Cyano, Nitro, C₁-C₆Alkyl oder C₁-C₆Alkoxy substituiertes Phenyl bedeuten,
R₁₂ und R₁₃ C₁-C₆Alkyl, R₁₄ Wasserstoff oder C₁-C₆Alkyl und R₁₅ Wasserstoff, C₁-C₆Alkyl, unsubstituiertes oder durch C₁-C₆Alkyl substituiertes Phenyl bedeuten,
Q unsubstituiertes oder einfach oder mehrfach mit C₁-C₆Alkoxy, C₁-C₆Alkythio oder C₂-C₁₂Dialkylamino substituiertes p,q-C₂-C₆Alkylen bedeutet, wobei p und q unterschiedliche Positionszahlen sind,
X ein Heteroatom, ausgewählt aus der Gruppe bestehend aus N, O oder S bedeutet, wobei m wenn X gleich O oder S ist für die Zahl 0 und wenn X gleich N ist für die Zahl 1 steht, und
L₁ und L₂ unabhängig voneinander unsubstituiertes oder einfach oder mehrfach mit C₁-C₁₂Alkoxy, C₁-C₁₂Alkylthio, C₂-C₂₄Dialkylamino, C₆-C₁₂Aryloxy, C₆-C₁₂Arylthio, C₇-C₂₄Alkylarylamino oder C₁₂-C₂₄Diarylamino substituiertes C₁-C₆Alkyl oder [-(p',q'-C₂-C₆Alkylen)-Z-]ₙ-C₁-C₆Alkyl sind, wobei n eine Zahl von 1 bis 1000 ist, p' und q' unterschiedliche Positionszahlen sind, jedes Z unabhängig von den anderen ein Heteroatom O, S oder mit C₁-C₁₂Alkyl substituiertes N bedeutet, und C₂-C₆Alkylen in den sich wiederholenden Einheiten [-C₂-C₆Alkylen-Z-] gleich oder verschieden sein kann,
und L₁ und L₂ gesättigt oder 1- bis 10-mal ungesättigt sein können, ununterbrochen oder an beliebigen Stellen durch 1 bis 10 Gruppen, ausgewählt aus der Gruppe bestehend aus -(C=O)- und -C₆H₄-, unterbrochen sein können, und keine oder 1 bis 10 weitere Substituenten, ausgewählt aus der Gruppe bestehend aus Halogen, Cyano oder Nitro, tragen können.

Von besonderem Interesse sind Verbindungen der Formel (I), worin L für C₁-C₆Alkyl, C₂-C₆Alkenyl oder 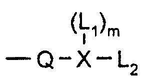 steht, worin Q C₂-C₄Alkylen, und L₁ und L₂[-C₂-C₁₂Alkylen-Z-]ₙ-C₁-C₁₂Alkyl oder einfach oder mehrfach mit C₁-C₁₂Alkoxy, C₁-C₁₂Alkythio oder C₂-C₂₄Dialkylamino substituiertes C₁-C₁₂Alkyl bedeuten, und m und n die zuvor gegebene Definition haben.

Von ganz besonderem Interesse sind Verbindungen der Formel (I). worin L für C₄-C₅Alkyl, C₃-C₆Alkenyl oder 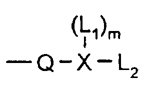 steht, worin Q C₂-C₄Alkylen bedeutet, X für O und m für Null stehen, und L₂ [-C₂-C₁₂Alkylen-O-]ₙ-C₁-C₁₂Alkyl oder einfach oder mehrfach mit C₁-C₁₂Alkoxy substituiertes C₁-C₁₂Alkyl ist, insbesondere jene, worin -Q-X- für eine Gruppe der Formel

-C(CH₃)₂-CH₂-O-

steht.

Alkyl oder Alkylen kann geradkettig, verzweigt, monozyclisch oder polyzyclisch sein.

C₁-C₁₂Alkyl ist daher zum Beispiel Methyl, Ethyl, n-Propyl, Isopropyl, n-Butyl, sec.-Butyl, Isobutyl, tert.-Butyl, Cyclobutyl, n-Pentyl, 2-Pentyl, 3-Pentyl, 2,2-Dimethylpropyl, Cyclopentyl, Cyclohexyl, n-Hexyl, n-Octyl, 1,1,3,3-Tetramethylbutyl, 2-Ethylhexyl, Nonyl, Trimethylcyclohexyl, Decyl, Menthyl, Thujyl, Bornyl, 1-Adamantyl, 2-Adamantyl oder Dodecyl.

Falls C₂-C₁₂Alkyl ein- oder mehrfach ungesättigt ist, handelt es sich um C₂-C₁₂Alkenyl, C₂-C₁₂Alkinyl, C₂-C₁₂Alkapolyenyl oder C₂- C₁₂Alkapolyinyl, wobei zwei oder mehr Doppelbindungen gegebenenfalls isoliert oder konjugiert sein können, wie zum Beispiel Vinyl, Allyl, 2-Propen-2-yl, 2-Buten-1-yl, 3-Buten-1-yl, 1,3-Butadien-2-yl, 2-Cyclobuten-1-yl, 2-Penten-1-yl, 3-Penten-2-yl, 2-Methyl-1-buten-3-yl, 2-Methyl-3-buten-2-yl, 3-Methyl-2-buten-1-yl, 1,4-Pentadien-3-yl, 2-Cyclopenten-1-yl, 2-Cyclohexen-1-yl, 3-Cyclohexen-1-yl, 2,4-Cyclohexadien-1-yl, 1-*p*-Menthen-8-yl, 4(10)-Thujen-10-yl, 2-Norbornen-1-yl, 2,5-Norbornadien-1-yl, 7,7-Dimethyl-2,4-norcaradien-3-yl oder die verschiedenen Isomeren von Hexenyl, Octenyl, Nonenyl, Decenyl oder Dodecenyl.

C₂-C₄Alkylen ist zum Beispiel 1,2-Ethylen, 1,2-Propylen, 1,3-Propylen, 1,2-Butylen, 1,3-Butylen, 2,3-Butylen, 1,4-Butylen oder 2-Methyl-1,2-propylen. C₅-C₁₂Alkylen ist zum Beispiel ein Isomer von Pentylen, Hexylen, Octylen, Decylen oder Dodecylen.

C₁-C₁₂Alkoxy ist O-C₁-C₁₂Alkyl, bevorzugt O-C₁-C₄Alkyl.

C₆-C₁₂Aryloxy ist O-C₆-C₁₂Aryl, beispielsweise Phenoxy oder Naphthoxy, bevorzugt Phenoxy.

C₁-C₁₂Alkylthio ist S-C₁-C₁₂Alkyl, bevorzugt S-C₁-C₄Alkyl.

C₆-C₁₂Arylthio ist S-C₆-C₁₂Aryl, beispielsweise Phenylthio oder Naphthylthio, bevorzugt Phenylthio.

C₂-C₂₄Dialkylamino ist N(Alkyl₁)(Alkyl₂), wobei die Summe der Kohlenstoffatome in den beiden Gruppen Alkyl₁ und Alkyl₂ von 2 bis 24 beträgt, bevorzugt N(C₁-C₄Alkyl)-C₁-C₄Alkyl.

C₇-C₂₄Alkylarylamino ist N(Alkyl₁)(Aryl₂), wobei die Summe der Kohlenstoffatome in den beiden Gruppen Alkyl₁ und Aryl₂ von 7 bis 24 beträgt, beispielsweise Methylphenylamino Ethylnaphthylamino oder Butylphenanthrylamino, bevorzugt Methylphenylamino oder Ethylphenylamino.

C₁₂-C₂₄Diarylamino ist N(Aryl₁)(Aryl₂), wobei die Summe der Kohlenstoffatome in den beiden Gruppen Aryl₁ und Aryl₂ von 12 bis 24 beträgt, beispielsweise Diphenylamino oder Phenylnaphthylamino, bevorzugt Diphenylamino.

Halogen ist Chlor, Brom, Fluor oder Jod, bevorzugt Fluor oder Chlor, insbesondere Chlor.

n ist bevorzugt eine Zahl von 1 bis 100, besonders bevorzugt eine Zahl von 2 bis 12.

Zweckmässig ist eine Temperatur von 0 bis 160°C, bevorzugt von 10 bis 100°C, während ½ bis 80 Stunden, bevorzugt von 2 bis 48 Stunden, umgesetzt. Die Reaktion wird besonders bevorzugt bei 15 bis 60°C und einem Druck von 0,8 bis 1,2 bar, insbesondere von zirka 1 bar, durchgeführt.

Das jeweilige Molverhältnis richtet sich nach der Zahl der einzuführenden Resten D und E. Zweckmässig wird das Dicarbonat äquimolar oder in leichtem Überschuss eingesetzt, beispielsweise 1 bis 1,5 mol, bezogen auf 1 mol zu substituierende Wasserstoffatome (d.h. die molare Menge Dicarbonat entspricht 1-1,5 × Anzahl von Gruppen D und E im Molekül des Produktes der Formel A(D)ₓ(E)_{y} (I), welche nicht gleich Wasserstoff sind, für 1 mol Verbindung der Formel A(H)ₓ(H)_{y}).

Zweckmässigerweise verwendet man von 5 bis 50 Gewichtsteil aromatisches oder heteroaromatisches Lösungsmittel, bezogen auf 1 Gewichtsteil Verbindung der Formel A(H)ₓ(H)_{y}.

Als Katalysator geeignete Basen sind beispielsweise die Alkalimetalle selbst, wie Lithium, Natrium oder Kalium sowie deren Hydroxide und Carbonate, oder Alkaliamide, wie Lithium-, Natrium- oder Kaliumamid oder Alkalihydride, wie Lithium-, Natrium- oder Kaliumhydrid, oder Erdalkali- oder Alkalialkoholate, die sich insbesondere von primären, sekundären oder tertiären aliphatischen Alkoholen mit 1 bis 10 C-Atomen ableiten, wie zum Beispiel Lithium-, Natrium- oder Kaliummethylat, -ethylat, -n-propylat, -isopropylat, -n-butylat, -sek.-butylat, -tert.-butylat, -2-methyl-2-butylat, -2-methyl-2-pentylat, -3-methyl-3-pentylat, -3-ethyl-3-pentylat, und ferner organische aliphatische, aromatische oder heterocyclische N-Basen, darunter zum Beispiel Diazabicycloocten, Diazabicycloundecen und 4-Dimethylaminopyridin und Trialkylamine, wie zum Beispiel Trimethyl- oder Triethylamin. Man kann aber auch ein Gemisch der genannten Basen verwenden.

Bevorzugt werden die organischen N-Basen, wie zum Beispiel Diazabicyclooctan, Diazabicycloundecen und insbesondere 4-Dimethylaminopyridin.

Die Menge Katalysator beträgt zweckmässig von 0,005 bis 2 mol, bevorzugt von 0,02 bis 1 mol, besonders bevorzugt von 0,1 bis 0,4 mol, mal die Anzahl von Gruppen D und E im Molekül des Produktes der Formel A(D)ₓ(E)_{y} (I), welche nicht gleich Wasserstoff sind, bezogen auf 1 mol Verbindung der Formel A(H)ₓ(H)_{y}. Für die Substitution einer einzigen Gruppe braucht man daher von 0,005 bis 2 mol Katalysator, für die Substitution von 6 Gruppen dagegen von 0,03 bis 12 mol Katalysator.

Die geeigneten Pyrokohlensäurediester der Formel 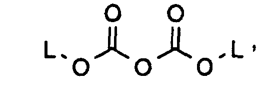 können in Analogie zu allgemein bekannten Methoden hergestellt werden. Die meisten dazu benötigten Chemikalien sind bekannt. Viele sind kommerziell erhältlich und alle können nach an sich bekannten Methoden hergestellt werden.

Das Produkt der Formel A(D)ₓ(E)_{y} (I) kann aus dem Reaktionsgemisch durch übliche Methoden isoliert werden. Bevorzugt wird es mit einem oder mehreren Lösungsmitteln gefällt, worin es schwerlöslich ist, besonders bevorzugt mit einem gesättigten Kohlenwasserstoff, einem aliphatischen Alkohol, Wasser oder einem Gemisch eines gesättigten Kohlenwasserstoffs und eines aliphatischen Alkohols oder eines aliphatischen Alkohols und Wassers, wobei besonders vorteilhaft der Katalysator in Lösung bleibt. Ganz besonders bevorzugt wird gefällt mit 50 bis 150 Gewichts% Lösungsmittel, worin das Produkt schwerlöslich ist, wobei diese Menge auf die Verbindung der Formel A(H)ₓ(H)_{y} bezogen ist.

Gegebenenfalls ist es von Vorteil, die Menge Lösungsmittel vor der Fällung auf eine der Löslichkeit des Produktes entsprechenden Menge zu reduzieren, zum Beispiel auf 0,5 bis 5 Gewichtsteile aromatisches Lösungsmittel, bezogen auf 1 Gewichtsteil Verbindung der Formel A(H)ₓ(H)_{y}.

Die nachfolgenden Beispiele erläutern die Erfindung, ohne deren Umfang einzuschränken:

Beispiel 1: In einem 1,5 I Reaktionsgefäss, das mit einem Rührer, Thermometer und einem Stickstoffzugang versehen ist, werden 50,0 g Pigment Red 222 in 500 ml o-Xylol suspendiert. Bei Raumtemperatur werden 4,4 g Dimethylaminopyridin und 88,7 g di-t-Amylpyrocarbonat zugegeben. Die Reaktionsmischung wird bei 23°C 16 Stunden gerührt. Anschliessend wird die Lösung unter vermindertem Druck bei 40°C zu einem Drittel des Volumens eingeengt, dann mit 60 ml Ethanol versetzt. Unter schnellem Rühren werden 600 ml n-Hexan zugetropft. Das ausgefällte Produkt wird filtriert, mit Hexan gewaschen und bei 40°C / 20 mbar getrocknet. Man bekommt 80,7 g (98% d.Th.) eines ausgezeichnet reinen, hellroten Pulvers der Struktur:

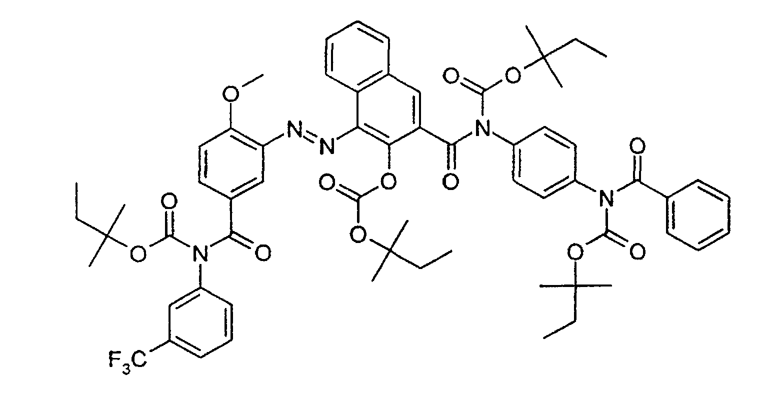

Die ¹H-NMR-, TGA- und C,N,H,F-Analysendaten stimmen mit der Struktur überein. Die Reinheit (Bestimmt durch HPLC): 99%.

Beispiele 2: In einem 63 I Reaktionsgefäss werden 4,0 kg Pigment Red 222 in 36 kg o-Xylol suspendiert. Bei 25°C werden 352 g Dimethylaminopyridin und 7,1 kg di-t-Amylpyrocarbonat zugegeben. Die Reaktionsmischung wird dann 3 Stunden unter Rühren auf 40°C erhitzt. Anschliessend wird die Lösung unter vermindertem Druck bei 40°C eingeengt, wobei 25 I o-Toluol zurückgewonnen werden. Die Ausfällung des roten Produktes wird mit 4 kg Ethanol ausgelöst und durch die Zugabe von 17 kg Hexan vervollständigt. Das Produkt wird filtriert, mit 17 kg Hexan gewaschen und bei 40°C / 20 mbar getrocknet. Man bekommt 6,39 kg (97% d.Th.) eines ausgezeichnet reinen Pulvers der gleichen Struktur, wie im Beispiel 1.

Beispiel 3: Eine Suspension von 18,74 g Pigment Yellow 93, 1,01 g Dimethylaminopyridin und 34,9 g di-t-Butylpyrocarbonat in 200 ml Toluol wird 5½ Std bei 40°C gerührt. Das Reaktionsgemisch wird abfiltriert und das Filtrat zur Trockene eingeengt und mit Hexan gewaschen. Der Rückstand wird in 100 ml Ethanol aufgenommen und mit 4 I deionisiertem Wasser ausgefällt. Das ausgefällte Produkt wird filtriert und bei 40°C / 20 mbar getrocknet. Man bekommt 30,44 g (99% d.Th.) eines beige-braunen Pulvers, dessen Hauptkomponente (78%) der folgenden Struktur entspricht:

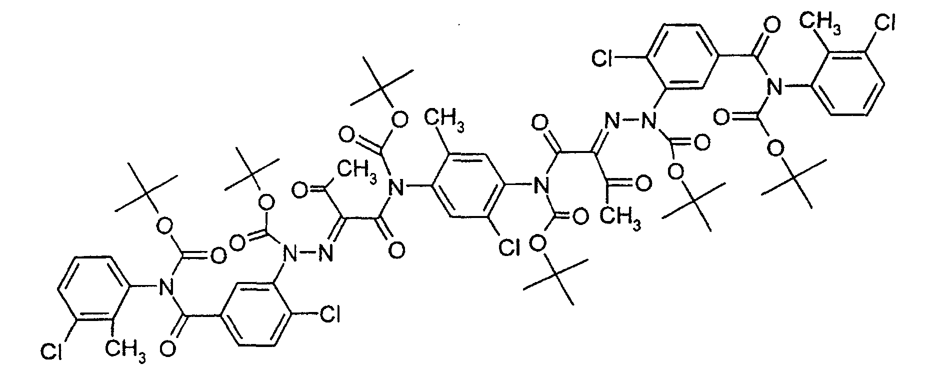

Beispiel 4: 5,00 g Pigment Yellow 93, 0,3 g Dimethylaminopyridin und 11,4 g Di-(2-methyl-3-buten-2)-pyrocarbonat werden in einem Gemisch von 35 ml o-Xylol und 15 ml Pyridin suspendiert und bei 20°C 16 Std gerührt. Das Reaktionsgemisch wird abfiltriert, das Filtrat zur Trockene eingeengt und mit Hexan gewaschen. Der Rückstand wird in 30 ml Ethanol aufgenommen und mit 300 ml Hexan ausgefällt. Man erhält 7,97 g (89% d.Th.) eines beige-braunen Pulvers, dessen Hauptkomponente (82%) der folgenden Struktur entspricht:

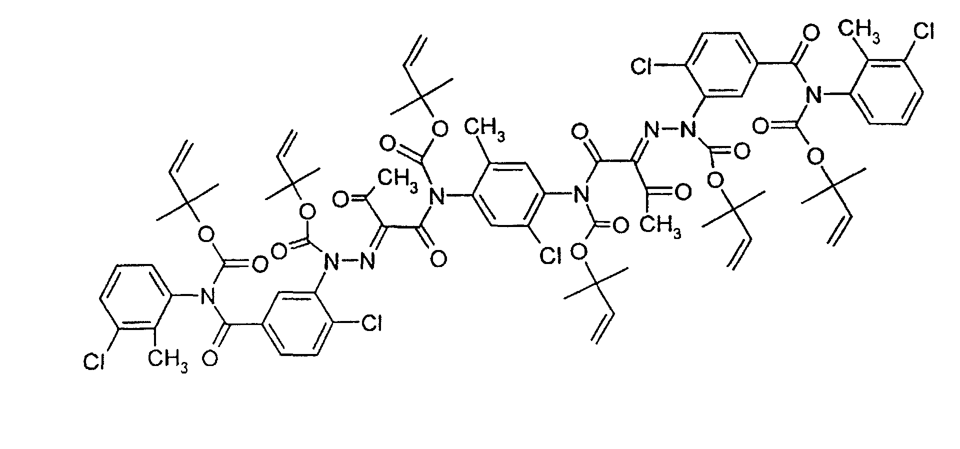

Beispiel 5: Das Produkt gemäss Beispiel 1 von WO 98/45756 wird zunächst unter üblichen Bedingungen mit Ethanolamin in Kupferphthalocyanin-tetrakis-β-hydroxyethyl-sulfonamid überführt. 3,0 g dieses Produkts werden in 0,5 g Dimethylaminopyridin, 8.0 g di-t-Butylpyrocarbonat und 50 ml Toluol unter kräftigem Rühren bei 23°C suspendiert. Die Reaktionsmischung wird 4 Stunden bei 40°C weitergerührt, anschliessend durch 5 g Kieselgur (Hyflo Super Cel®, Fluka AG) filtriert. Der Filterrückstand wird mit Toluol nachgewaschen, bis das Eluat fast farblos ist. Nach Einengen des Filtrats bei ∼40°C / 30 mbar werden 100 ml eines Gemisches von 75 ml n-Heptan und 25 ml 2-Propanol zugegeben. Der Niederschlag wird abfiltiert, mit zirka 10 ml n-Heptan gewaschen und bei 23°C / 120 mbar getrocknet. Man bekommt 4,5 g eines reinen, blauen Pulvers der Formel:

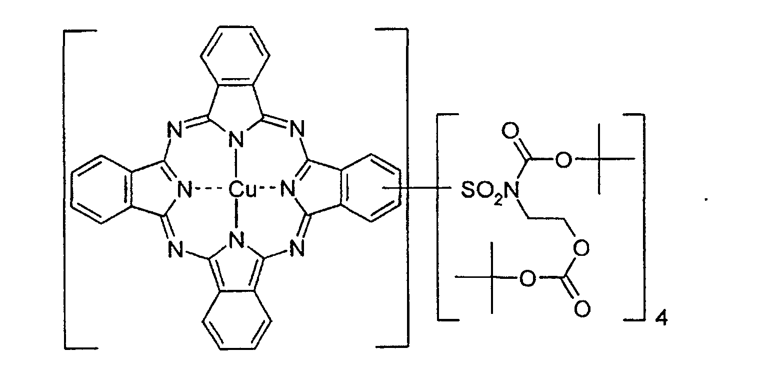

| Elementaranalyse [%]: (C₈₀H₁₀₀N₁₂O₂₈S₄Cu) | | | | | |
|---|---|---|---|---|---|
| theor. | C 51,40 | H 5,39 | N 8,99 | S 6,86 | Cu 3,40 |
| gef. | C 51,18 | H 5,46 | N 9,18 | S 6,83 | Cu 3,56 |

### Thermogravimetrische Analyse: Gewichtsverlust 41,9% [ = 8x -COOC(CH₃)₃].

Das Produkt weist weder NH noch OH Gruppen auf, ist in üblichen Lösungsmitteln in hohen Konzentrationen klar löslich und ergibt ausgezeichnete Pigmentierungen, beispielsweise auf Holz gemäss den in WO-A-98/58027 und EP-99811238.9 offenbarten Verfahren.

## Patentansprüche

1. Verfahren zur Herstellung einer Verbindung der Formel A(D)ₓ(E)_{y} (I) durch Reaktion einer Verbindung der Formel A(H)ₓ(H)_{y} mit einem Pyrokohlensäurediester der Formel 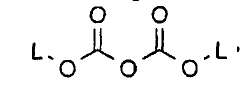 worin
x und y unabhängig voneinander je eine ganze Zahl von 0 bis 6 bedeuten, jedoch nicht gleichzeitig x und y die Zahl 0,
A für den Rest eines Chromophors der Chinacridon-, Anthrachinon-, Perylen-, Indigo-, Chinophthalon-, Indanthron-, Isoindolinon-, Isoindolin-, Dioxazin, Azo-, Phthalocyanin- oder Diketopyrrolopyrrol-reihe steht, der über ein oder mehrere N-Atome mit x Gruppen D und über ein oder mehrere O-Atome mit y Gruppen E verbunden ist, wobei diese N-Atome und O-Atome Teil des Restes A bilden,
jede Gruppe D oder E unabhängig von den anderen für Wasserstoff oder eine Gruppe der Formel 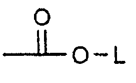 steht, wobei mindestens eine Gruppe D oder E nicht Wasserstoff ist, und L eine beliebige, zur Solubilisierung geeignete Gruppe bedeutet,
in Gegenwart einer Base als Katalysator, **dadurch gekennzeichnet, dass** diese Reaktion in einem aromatischen oder heteroaromatischen Lösungsmittel stattfindet, ausgewählt aus unsubstituiertem oder mit 1 bis 3 C₁-C₂₄Alkyl, Phenyl, Benzyl, C₁-C₂₄Alkoxy, Phenoxy, C₁-C₂₄Alkylthio, Halogen und/oder Nitro substituiertem Benzol, Diphenyl, Pyridin, Chinolin und Pyrrol sowie beliebigen Gemischen davon.

2. Verfahren gemäss Anspruch 1, worin es sich beim aromatischen Lösungsmittel um unsubstituiertes oder mit 1 bis 3 C₁-C₆Alkyl, C₁-C₆Alkoxy oder Halogen substituiertes Benzol handelt.

3. Verfahren gemäss Anspruch 1, worin A für den Rest eines Chromophors der Monoazo-, Disazo- oder Phthalocyanin-reihe steht.

4. Verfahren gemäss Anspruch 1, worin zumindest eine Gruppe D, welche ungleich Wasserstoff ist, am N-Atom einer Hydrazon- oder Sulfonamidgruppe gebunden ist, oder worin zumindest eine Gruppe E, welche ungleich Wasserstoff ist, am O-Atom eines Enols, Phenols oder Naphthols gebunden ist.

5. Verfahren gemäss Anspruch 1, worin in Formel A(D)ₓ(E)_{y} (I) von 4 bis 8 Gruppen D und E nicht Wasserstoff sind.

6. Verfahren gemäss Anspruch 1, worin in Formel A(D)ₓ(E)_{y} (I) alle Gruppen D und E je für eine Gruppe der Formel 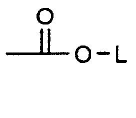 stehen.

7. Verfahren gemäss Anspruch 1, worin L für eine Gruppe der Formel 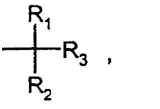 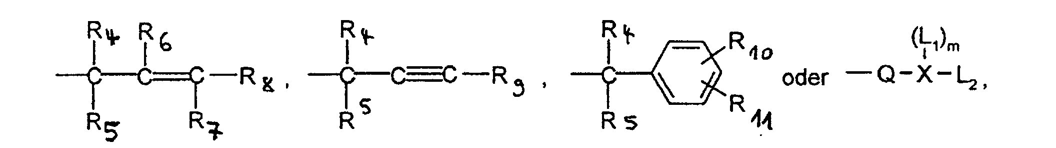 worin R₁, R₃ und R₂ unabhängig voneinander C₁-C₆Alkyl bedeuten,
R₄ und R₅ unabhängig voneinander C₁-C₆Alkyl, durch O, S oder N(R₁₂) unterbrochenes C₁-C₆Alkyl, unsubstituiertes oder durch C₁-C₆Alkyl, C₁-C₆Alkoxy, Halogen, Cyano oder Nitro substituiertes Phenyl oder Biphenyl bedeuten,
R₆, R₇ und R₈ unabhängig voneinander Wasserstoff oder C₁-C₆Alkyl bedeuten,
R₉ Wasserstoff, C₁-C₆Alkyl oder eine Gruppe der Formel 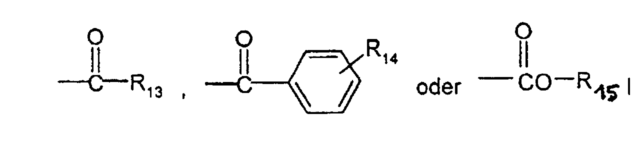 bedeutet,
R₁₀ und R₁₁ unabhängig voneinander Wasserstoff. C₁-C₆Alkyl, C₁-C₆Alkoxy, Halogen, Cyano, Nitro, N(R₁₂)₂, unsubstituiertes oder durch Halogen, Cyano, Nitro, C₁-C₆Alkyl oder C₁-C₆Alkoxy substituiertes Phenyl bedeuten,
R₁₂ und R₁₃ C₁-C₆Alkyl, R₁₄ Wasserstoff oder C₁-C₆Alkyl und R₁₅ Wasserstoff, C₁-C₆Alkyl, unsubstituiertes oder durch C₁-C₆Alkyl substituiertes Phenyl bedeuten,
Q unsubstituiertes oder einfach oder mehrfach mit C₁-C₆Alkoxy, C₁-C₆Alkythio oder C₂-C₁₂Dialkylamino substituiertes p,q-C₂-C₆Alkylen bedeutet, wobei p und q unterschiedliche Positionszahlen sind,
X ein Heteroatom, ausgewählt aus der Gruppe bestehend aus N, O oder S bedeutet, wobei m wenn X gleich O oder S ist für die Zahl 0 und wenn X gleich N ist für die Zahl 1 steht, und
L₁ und L₂ unabhängig voneinander unsubstituiertes oder einfach oder mehrfach mit C₁-C₁₂Alkoxyl C₁-C₁₂Alkylthio, C₂-C₂₄Dialkylamino, C₆-C₁₂Aryloxy, C₆-C₁₂Arylthio, C₇-C₂₄Alkylarylamino oder C₁₂-C₂₄Diarylamino substituiertes C₁-C₆Alkyl oder [-(p',q'-C₂-C₆Alkylen)-Z-]ₙ-C₁-C₆Alkyl sind, wobei n eine Zahl von 1 bis 1000 ist, p' und q' unterschiedliche Positionszahlen sind, jedes Z unabhängig von den anderen ein Heteroatom O, S oder mit C₁-C₁₂Alkyl substituiertes N bedeutet, und C₂-C₆Alkylen in den sich wiederholenden Einheiten [-C₂-C₆Alkylen-Z-] gleich oder verschieden sein kann,
und L₁ und L₂ gesättigt oder 1- bis 10-mal ungesättigt sein können, ununterbrochen oder an beliebigen Stellen durch 1 bis 10 Gruppen, ausgewählt aus der Gruppe bestehend aus -(C=O)- und -C₆H₄-, unterbrochen sein können, und keine oder 1 bis 10 weitere Substituenten, ausgewählt aus der Gruppe bestehend aus Halogen, Cyano oder Nitro, tragen können, steht.

8. Verfahren gemäss Anspruch 1, worin von 5 bis 50 Gewichtsteil aromatisches oder heteroaromatisches Lösungsmittel verwendet werden, bezogen auf 1 Gewichtsteil Verbindung der Formel A(H)ₓ(H)_{y}.

9. Verfahren gemäss Anspruch 1, worin die Temperatur von 0 bis 160°C und die Reaktionszeit von ½ bis 80 Stunden betragen.

10. Verfahren gemäss Anspruch 1, worin es sich beim Katalysator um ein Alkalimetall oder Erdalkalimetall, oder ein Hydroxid, Carbonat, Amid, Hydrid oder Alkoholat davon, oder um eine organische aliphatische, aromatische oder heterocyclische N-Base, oder um ein Gemisch davon handelt.

11. Verfahren gemäss Anspruch 1, worin die Menge Katalysator von 0,005 bis 2 mol, bevorzugt von 0,02 bis 1 mol, besonders bevorzugt von 0,1 bis 0,4 mol, mal die Anzahl von Gruppen D und E im Molekül des Produktes der Formel A(D)ₓ(E)_{y} (I), welche nicht gleich Wasserstoff sind, bezogen auf 1 mol Verbindung der Formel A(H)ₓ(H)_{y}, beträgt.

12. Verfahren gemäss Anspruch 1, worin es sich bei der Verbindung der Formel A(H)ₓ(H)_{y} um Colour Index Pigment Yellow 13, Pigment Yellow 93, Pigment Yellow 94, Pigment Yellow 95, Pigment Yellow 128, Pigment Yellow 154, Pigment Red 185 und Pigment Red 222 handelt.

## Claims

1. A method for preparing a compound of the formula A(D)ₓ(E)_{y} (I) by reaction of a compound of the formula A(H)ₓ(H)_{y} with a pyrocarbonic acid diester of the formula 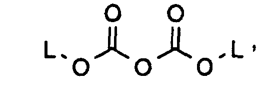 wherein
x and y are each independently of the other an integer from 0 to 6, but x and y are not simultaneously the number 0,
A is the radical of a chromophore of the quinacridone, anthraquinone, perylene, indigo, quinophthalone, indanthrone, isoindolinone, isoindoline, dioxazine, azo, phthalocyanine or diketopyrrolopyrrole series, which radical is bonded *via* one or more nitrogen atoms to x groups D and *via* one or more oxygen atoms to y groups E, the nitrogen atoms and oxygen atoms forming part of the radical A,
each group D or E independently of any other(s) is hydrogen or a group of the formula 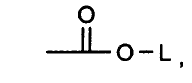 wherein at least one group D or E is not hydrogen, and L is any desired group suitable for solubilisation,
in the presence of a base as catalyst, in which method the reaction takes place in an aromatic or heteroaromatic solvent selected from diphenyl, pyridine, quinoline, pyrrole and benzene unsubstituted or mono- to tri-substituted by C₁-C₂₄alkyl, phenyl, benzyl, C₁-C₂₄-alkoxy, phenoxy, C₁-C₂₄alkylthio, halogen and/or by nitro, and any desired mixtures thereof.

2. A method according to claim 1, wherein the aromatic solvent is benzene that is unsubstituted or mono- to tri-substituted by C₁-C₆alkyl, C₁-C₆alkoxy or by halogen.

3. A method according to claim 1, wherein A is the radical of a chromophore of the monoazo, disazo or phthalocyanine series.

4. A method according to claim 1, wherein at least one group D that is other than hydrogen is bonded to the nitrogen atom of a hydrazone or sulfonamide group, or wherein at least one group E that is other than hydrogen is bonded to the oxygen atom of an enol, phenol or naphthol.

5. A method according to claim 1, wherein in the formula A(D)ₓ(E)_{y} (I) from 4 to 8 groups D and E are not hydrogen.

6. A method according to claim 1, wherein in the formula A(D)ₓ(E)_{y} (I) all the groups D and E are each a group of the formula

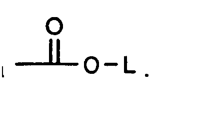

7. A method according to claim 1, wherein L is a group of the formula 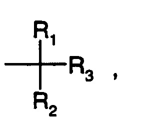 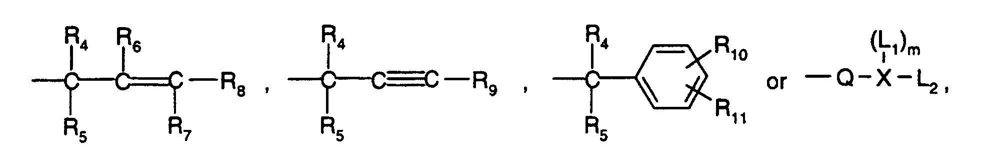 wherein R₁, R₃ and R₂ are each independently of the others C₁-C₆alkyl,
R₄ and R₅ are each independently of the other C₁-C₆alkyl, C₁-C₆alkyl interrupted by O, S or by N(R₁₂)₂, unsubstituted or C₁-C₆alkyl-, C₁-C₆alkoxy-, halo-, cyano- or nitro-substituted phenyl or biphenyl,
R₆, R₇ and R₈ are each independently of the others hydrogen or C₁-C₆alkyl,
R₉ is hydrogen, C₁-C₆alkyl or a group of the formula 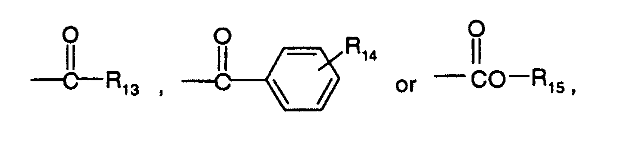 R₁₀ and R₁₁ are each independently of the other hydrogen, C₁-C₆alkyl, C₁-C₆alkoxy, halogen, cyano, nitro, N(R₁₂)₂, unsubstituted or halo-, cyano-, nitro-, C₁-C₆alkyl- or C₁-C₆alkoxy-substituted phenyl,
R₁₂ and R₁₃ are C₁-C₆alkyl, R₁₄ is hydrogen or C₁-C₆alkyl and R₁₅ is hydrogen, C₁-C₆alkyl, unsubstituted or C₁-C₆alkyl-substituted phenyl,
Q is p,q-C₂-C₆alkylene that is unsubstituted or mono- or poly-substituted by C₁-C₆alkoxy, C₁-C₆alkylthio or by C₂-C₁₂dialkylamino, wherein p and q are different position numbers,
X is a hetero atom selected from the group consisting of N, O and S, m being the number 0 when X is O or S and the number 1 when X is N, and
L₁ and L₂ are each independently of the other [-(p',q'-C₂-C₆alkylene)-Z-]ₙ-C₁-C₆alkyl or C₁-C₆alkyl unsubstituted or mono- or poly-substituted by C₁-C₁₂alkoxy, C₁-C₁₂alkylthio, C₂-C₂₄dialkylamino, C₆-C₁₂aryloxy, C₆-C₁₂arylthio, C₇-C₂₄alkylarylamino or by C₁₂-C₂₄-diarylamino, wherein n is a number from 1 to 1000, p' and q' are different position numbers, each Z independently of the other(s) is a hetero atom O, S or C₁-C₁₂alkyl-substituted N, and C₂-C₆alkylene in the repeating units [-C₂-C₆alkylene-Z-] may be the same or different,
and L₁ and L₂ may be saturated or unsaturated from 1 to 10 times, may be uninterrupted or interrupted at any desired positions by from 1 to 10 groups selected from the group consisting of -(C=O)- and -C₆H₄-, and may carry no further substituents or from 1 to 10 further substituents selected from the group consisting of halogen, cyano and nitro.

8. A method according to claim 1, wherein from 5 to 50 parts by weight of aromatic or heteroaromatic solvent are used, based on 1 part by weight of compound of the formula A(H)ₓ(H)_{y}.

9. A method according to claim 1, wherein the temperature is from 0 to 160°C and the reaction time is from ½ to 80 hours.

10. A method according to claim 1, wherein the catalyst is an alkali metal or alkaline earth metal, or a hydroxide, carbonate, amide, hydride or alcoholate thereof, or an organic aliphatic, aromatic or heterocyclic nitrogen base, or a mixture thereof.

11. A method according to claim 1, wherein the amount of catalyst is from 0.005 to 2 mol, preferably from 0.02 to 1 mol, especially from 0.1 to 0.4 mol, times the number of groups D and E in the molecule of the product of the formula A(D)ₓ(E)_{y} (I) that are other than hydrogen, based on 1 mol of compound of the formula A(H)ₓ(H)_{y}.

12. A method according to claim 1, wherein the compound of the formula A(H)ₓ(H)_{y} is Colour Index Pigment Yellow 13, Pigment Yellow 93, Pigment Yellow 94, Pigment Yellow 95, Pigment Yellow 128, Pigment Yellow 154, Pigment Red 185 or Pigment Red 222.

## Revendications

1. Procédé pour la préparation d'un composé de formule A(D)ₓ(E)_{y}(I) par réaction d'un composé de formule A(H)ₓ(H)_{y} sur un diester d'acide pyrocarbonique de formule 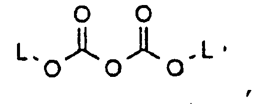 où
x et y représentent chacun, indépendamment l'un de l'autre, un entier de 0 à 6, mais x et y ne valent pas simultanément zéro,
A représente le reste d'un chromophore de la série de quinacridone, d'anthraquinone, de pérylène, d'indigo, de quinophtalone, d'indanthrone, d'isoindolinone, d'isoindoline, de dioxazine, azoïque, de phtalocyanine ou de dicétopyrrolopyrrole, qui est lié par l'intermédiaire d'un ou plusieurs atomes de N à x groupes D et par l'intermédiaire d'un ou plusieurs atomes de O à y groupes E, ces atomes de N et de O faisant partie du reste A,
chaque groupe D ou E représentent, indépendamment l'un de l'autre, des atomes d'hydrogène ou un groupe de formule 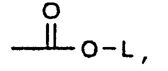 au moins un groupe D ou E ne représentant pas un atome d'hydrogène, et L représente un groupe quelconque, approprié à la solubilisation,
en présence d'une base comme catalyseur, **caractérisé en ce que** cette réaction est mise en oeuvre dans un solvant aromatique ou hétéroaromatique, pris dans le groupe comprenant le benzène, le diphényle, la pyridine, la quinoléine et le pyrrole non substitués ou substitués par 1 à 3 substituants alkyle en C₁-C₂₄, phényle, benzyle, alkoxy en C₁-C₂₄, phénoxy, (alkyl en C₁-C₂₄)thio, halogène et/ou nitro, ainsi que leurs mélanges.

2. Procédé selon la revendication 1, où il s'agit, pour le solvant aromatique, de benzène non substitué ou substitué par 1 à 3 substituants alkyle en C₁-C₆, alkoxy en C₁-C₆ ou halogène.

3. Procédé selon la revendication 1, où A représente le reste d'un chromophore de la série monoazoïque, disazoïque ou de phtalocyanine.

4. Procédé selon la revendication 1, où au moins un groupe D, qui ne représente pas un atome d'hydrogène, est lié à l'atome de N d'un groupe hydrazone ou sulfonamido ou au moins un groupe E, qui ne représente pas un atome d'hydrogène, est lié à l'atome de O d'un énol, d'un phénol ou d'un naphtol.

5. Procédé selon la revendication 1, où à la formule A(D)ₓ(E)_{y}(I) 4 à 8 groupes D et E ne représentent pas des atomes d'hydrogène.

6. Procédé selon la revendication 1, où à la formule A(D)ₓ(E)_{y}(I) tous les groupes D et E représentent un groupe de formule

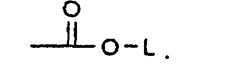

7. Procédé selon la revendication 1, où L représente un groupe, 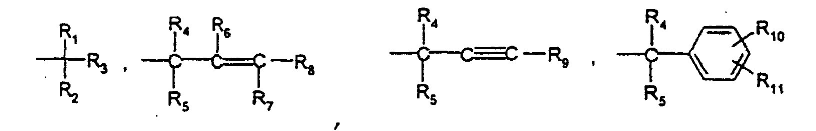 ou 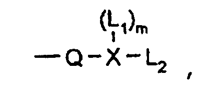 où
R₁, R₃ et R₂ représentent, indépendamment les uns des autres, un groupe alkyle en C₁-C₆,
R₄ et R₅ représentent, indépendamment l'un de l'autre, des groupes alkyle en C₁-C₆, alkyle en C₁-C₆ interrompu par des groupes O, S ou N(R₁₂), biphényle ou phényle non substitué ou substitué par des substituants alkyle en C₁-C₆, alkoxy en C₁-C₆, halogène, cyano ou nitro,
R₆, R₇ et R₈ représentent, indépendamment les uns des autres, un atome d'hydrogène ou un groupe alkyle en C₁-C₆.
R₉ représente un atome d'hydrogène ou un groupe de formule 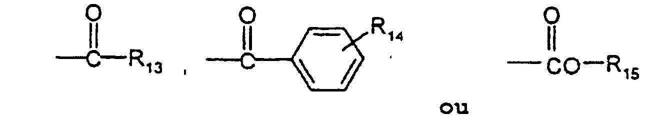 R₁₀ et R₁₁ représentent, indépendamment l'un de l'autre, des atomes d'hydrogène, des groupes alkyle en C₁-C₆, alkoxy en C₁-C₆, halogène, cyano, nitro, N(R₁₂)₂, phényle non substitué par des substituants halogène, cyano, nitro, alkyle en C₁-C₆ ou alkoxy en C₁-C₆.
R₁₂ et R₁₃ représentent un groupe alkyle en C₁-C₆, R₁₄ représente un atome d'hydrogène ou un groupe alkyle en C₁-C₆ et R₁₅ représente un atome d'hydrogène, un groupe alkyle en C₁-C₆ non substitué ou un groupe phényle substitué par un substituant alkyle en C₁-C₆,
Q représente des groupes p,q-alkylène en C₂-C₆ non substitué ou substitué une ou plusieurs fois par des substituants alkoxy en C₁-C₆, (alkyl en C₁-C₆)-thio ou di(alkyl en C₁-C₆)amino, p et q étant des chiffres de positions différents,
X représente un hétéroatome, pris dans le groupe constitué par des atomes de N, O ou S, lorsque X représente des atomes de O ou de S, m vaut 0 et lorsque X représente un atome de N, m vaut 1, et
L₁ et L₂ représentent, indépendamment l'un de l'autre, des groupes alkyle en C₁-C₆ ou [-(p',q'-alkylène en C₂-C₆)―Z―]ₙ―alkyle en C₁-C₆ non substitué ou substitué une ou plusieurs fois par des susbtituants alkoxy en C₁-C₁₂, (alkyl en C₁-C₁₂)thio, di(alkyl en C₂-C₂₄)amino, aryloxy en C₆-C₁₂, (aryl en C₆-C₁₂)thio, (alkylaryl en C₇-C₂₄)amino ou di(aryl en C₂-C₂₄)amino, n étant un nombre de 1 à 1000, p' et q' sont des nombres de position différents, chaque Z représente, indépendamment l'un de l'autre, un hétéroatome de O, S, ou un hétéroatome N substitué par un substituant alkyle en C₁-C₁₂, et les groupes alkylènes en C₂-C₆ dans les unités répétitives [―alkylène en C₂-C₆-Z-] peuvent être identiques ou différents,
et L₁ et L₂ peuvent être saturés ou insaturés 1 à 10 fois, non interrompus ou interrompus à n'importe quel endroit par 1 à 10 groupes pris dans le groupe comprenant -(C=O)- et -C₆H₄-, et peuvent ne pas porter de substituants ou porter 1 à 10 substituants pris dans le groupe comprenant des atomes d'halogènes, des groupes cyano ou nitro.

8. Procédé selon la revendication 1, où on utilise 5 à 50 parties en poids de solvant aromatique ou hétéroaromatique, par rapport à 1 partie en poids du composé de formule A(H)ₓ(H)_{y}.

9. Procédé selon la revendication 1, où la température est de 0 à 160°C et la durée réactionnelle de 0,5 à 80 heures.

10. Procédé selon la revendication 1, dans lequel il s'agit, pour le catalyseur, d'un métal alcalin ou alcalino-terreux, ou d'un hydroxyde, d'un carbonate, d'un amidure, d'un hydrure ou d'un alcoolate de ces métaux, ou d'une base azotée organique aliphatique, aromatique ou hétérocyclique, ou d'un mélange de ces substances.

11. Procédé selon la revendication 1, où la quantité de catalyseur est de 0,005 à 2 moles, de préférence de 0,02 à 1 mole, d'une manière particulièrement préférée de 0,1 à 0,4 moles, multipliée par le nombre de groupes D et E dans la molécule du produit de formule A(D)ₓ(E)_{y}(I) qui ne représentent pas des atomes d'hydrogène, par rapport 1 mole de composé de formule A(H)ₓ(H)_{y}.

12. Procédé selon la revendication 1, où il s'agit, pour le composé de formule A(H)ₓ(H)_{y} de Colour Index Pigment Yellow 13, Pigment Yellow 93, Pigment Yellow 94, Pigment Yellow 95, Pigment Yellow 128, Pigment Yellow 154, Pigment Red 185 et Pigment Red 222.
